Europäisches Patentamt

European Patent Office

Office européen des brevets

(19)

(11) Veröffentlichungsnummer : **0 483 702 B1**

## (12) EUROPÄISCHE PATENTSCHRIFT

(45) Veröffentlichungstag der Patentschrift :
**02.08.95 Patentblatt 95/31**

(21) Anmeldenummer : **91118283.0**

(22) Anmeldetag : **26.10.91**

(51) Int. Cl.⁶ : **H04R 25/00,** H03F 1/02,
H03G 7/00

(54) **Geschalteter Verstärker.**

(30) Priorität : **30.10.90 CH 3446/90**

(43) Veröffentlichungstag der Anmeldung :
**06.05.92 Patentblatt 92/19**

(45) Bekanntmachung des Hinweises auf die
Patenterteilung :
**02.08.95 Patentblatt 95/31**

(84) Benannte Vertragsstaaten :
**DE DK FR IT**

(56) Entgegenhaltungen :
**US-A- 4 592 087**
**IEEE JOURNAL OF SOLID-STATE CIRCUITS**
**Bd. 24, Nr. 2, April 1989, NEW YORK USSeiten**
**301 - 312 F. CALLIAS ET AL. 'A Set of Four IC's**
**in CMOS Technology for aProgrammable He-**
**aring Aid'**

(73) Patentinhaber : **ASCOM AUDIOSYS AG**
**Bernstrasse 41**
**CH-3175 Flamatt (CH)**

(72) Erfinder : **Callias, François**
**Chemin des Pavés 1**
**CH-2000 Neuchâtel (CH)**

(74) Vertreter : **Troesch Scheidegger Werner AG**
**Patentanwälte,**
**Siewerdtstrasse 95,**
**Postfach**
**CH-8050 Zürich (CH)**

## Beschreibung

Die vorliegende Erfindung betrifft ein Hörgerät mit geschaltetem Verstärker.

Geschaltete Verstärker, auch Klasse D-Verstärker genannt, für Hörgeräte-Anwendungen sind bekannt, so beispielsweise aus dem US-Patent 4, 592,087. Der Verstärker hat dabei die Aufgabe, das Mikrophon-Signal mit genügender Leistung an den Hörgeräte-Hörer abzugeben.

Im Vordergrund stehen bei einer Hörgeräte-Anwendung die Integrierbarkeit, d.h. der Verstärker soll als sogenannter integrierter Schaltkreis aufbaubar sein, und niedriger Stromverbrauch. Ein geschalteter Verstärker erfüllt diese Forderungen besser als ein Verstärker, der mit kontinuierlich angesteuerten Transistoren arbeitet (vergl. "Modulated Pulse Audio Power Amplifiers for integrated circuits" by H.R. Camenzind, IEEE-Trans. Vol. AU-14, Nr. 3, Sept. 1966).

Die genannten geschalteten Verstärker liefern auch ein Wechselspannungssignal U an den Hörer, wenn kein Tonsignal vom Mikrophon zugeliefert wird. Das Signal U ist in diesem Fall ohne Modulation und besteht nur aus einer Wechselspannungskomponente, deren Frequenz f hoch genug ist, um nicht vom Hörer als akustisches Signal abgestrahlt zu werden. Trotzdem fliesst im Hörer ein sogenannter Ruhestrom, der unerwünscht ist und in praktischen Fällen bis 50% der gesamten Ruhestromaufnahme des Hörgeräts ausmachen kann. Der Ruhestrom beträgt:

$$I = U / Z_f$$

Um I zu verkleinern, kann man die Impedanz $Z_f$ für die Frequenz f des unmodulierten Ausgangssignals U durch ein Tiefpassfilter erhöhen, was in Anwendung ausserhalb des Hörgeräte-Bereiches üblich ist, aber im Hörgerät zu viel Platz beanspruchen würde. Die Verkleinerung von U verkleinert zwar I, aber begrenzt die erzielbare Ausgangsleistung.

Die Aufgabe der Erfindung liegt in der Verminderung des Ruhestromes I im Hörer, ohne dafür ein voluminöses Filter einzusetzen und ohne die erzielbare Ausgangsleistung zu begrenzen.

Diese Aufgabe wird nun beim vorliegenden Hörgerät mit geschaltetem Verstärker dadurch gelöst, dass die Verstärkerschaltung derart ausgebildet ist, dass die Pulsamplitude des geschalteten Ausgangssignals des geschalteten Verstärkers in Abhängigkeit der Hüllkurve des zu verstärkenden Tonsignals verändert wird.

Das nachstehend beschriebene und in der Zeichnung dargestellte Ausführungsbeispiel wird an Hand eines pulstastverhältnismodulierten Verstärkers erläutert, ist aber auf alle geschalteten Verstärker anwendbar, bei denen in irgend einer Weise die Dauer der positiven und negativen Pulse moduliert wird.

In der Zeichnung zeigt:

Fig. 1     den Verlauf der vom Verstärker bei Abwesenheit einer Modulation an den Hörgeräte-Hörer gelieferten Ausgangsspannung;

Fig. 2     den Ruhestromverlauf im Hörer bei einer bestimmten reaktiven Impedanz des Hörers, und

Fig. 3     eine erfindungsgemässe Verstärkerschaltung.

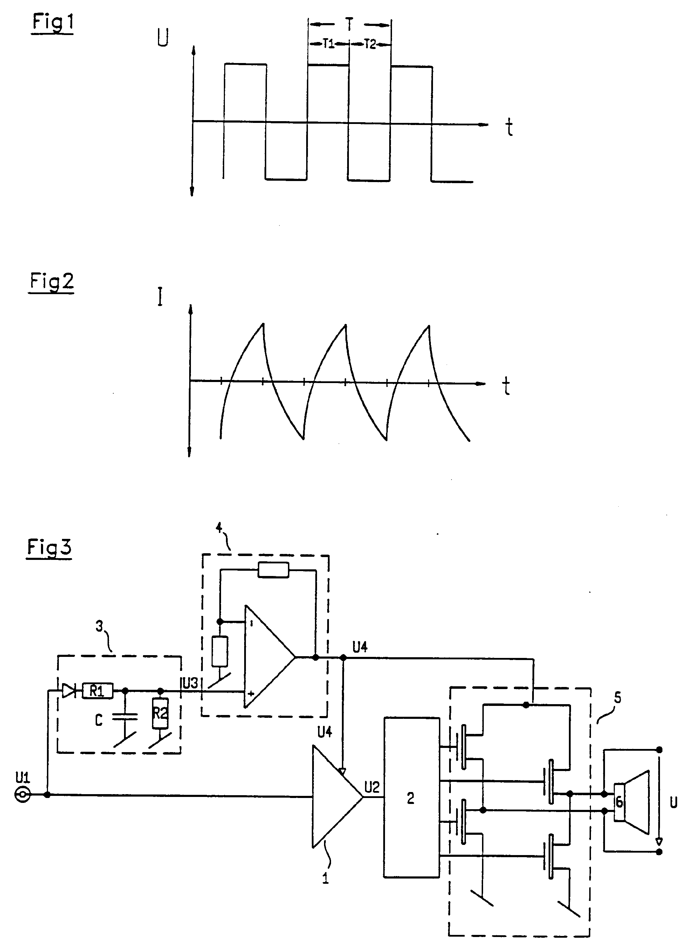

Wie erwähnt, zeigt Fig. 1 die Ausgangsspannung U, die der Verstärker bei Abwesenheit einer Modulation an den Hörgeräte-Hörer liefert. Bei Annahme einer bestimmten komplexen reaktiven Impedanz $Z_f$ des Hörers ergibt sich qualitativ der Verlauf des Ruhestromes I nach Fig.2.

Für alle geschalteten Verstärker ist $f = 1/T > 2f_{TON}$, wobei $f_{TON}$ die höchste wiederzugebende Tonfrequenz ist. In unmodulierten Fall ist $T_1/T_2 = 1$. Der Momentanwert der Tonsignalkomponenente $U_{TON}$ im Ausgangssignal U ist proportional zur Pulshöhe U und zum Tastverhältnis $T_1/T_2$. Der Ruhestrom I selbst ist nur abhängig von der Pulshöhe U. Die Aufgabe, den Ruhestrom I zu verkleinern, wird erfindungsgemäss dadurch gelöst, dass U verkleinert und der Betrag des Tastverhältnisses $T_1/T_2$ im gleichen Mass vergrössert wird. Da die maximal erreichbare Tonsignal-Leistung im Hörer quadratisch mit U abnimmt, muss diese Verkleinerung von U auf Fälle von kleinen oder abwesenden Tonsignalen beschränkt werden. Die Aufgabe, die Absenkung von U dem momentanen Tonsignal-Pegel anzupassen, übernimmt eine Steuerrschaltung nach Fig. 3, die nachfolgend beschrieben wird:

Das vom Mikophon gelieferte Tonsignal $U_1$ wird in bekannter Weise verstärkt und als $U_2$ dem Modulator 2 zugeführt. Der Modulator 2 und die Brückenschaltung 5 sind ebenfalls wie bei einem herkömmlichen geschalteten Verstärker ausgeführt. Der Hörer 6 wirkt als Last für die Ausgangsspannung U.

Beim erfindungsgemässen Hörgeräte-Verstärker ist nun die Speisung $U_4$ der Brücke 5 variabel ausgelegt. Bei kleinem oder abwesendem Tonsignal $U_1$ wird die Speisung $U_4$ und damit die Pulshöhe von U abgesenkt. Damit senkt sich auch der unerwünschte Ruhestrom I durch den Hörer G. Die Steuerung von $U_4$ erfolgt mit Hilfe des Gleichrichters und Filters 3 und des Verstärkers 4. Die gleichgerichtete und gefilterte Spannung $U_3$ ist etwa proportional dem Mittelwert von $U_1$. Im Tonsignal-Bereich haben sich Zeitkonstanten von $R_1C = 5$ ms und $R_2C = 100$ ms bewährt. $U_3$ und $U_4$ sind als Folge der Gleichrichtung und Filterung ungefähr ein Abbild der Umhüllenden des Tonsignals $U_1$. Für Tonsignale oberhalb eines bestimmten Pegels wird $U_4$ einen maximalen Wert erreichen; es kann auch für kleine Pegel von $U_1$ eine untere Grenze von $U_4$ vorgesehen werden.

2

Da die Tonsignalkomponente $U_{TON}$ von U proportional zu $U_4$ ist, würde die Verstärkung $U_{TON}/U_1$ mit dem Pegel von $U_1$ schwanken. Um $U_{TON}/U_1$ konstant zu halten, ist bei der vorliegenden Erfindung der Verstärker 1 als spannungsgesteuerter Verstärker ausgelegt. Seine Steuerspannung ist $U_4$ und die gewählte Charakteristik der Spannungsunabhängigkeit der Verstärkung $V = U_2/U_1$ ist

$$V \approx 1/U_4$$

Natürlich kann mit einer abweichenden Charakteristik eine Kompression oder Expansion von $U_{TON}/U_1$ erzielt werden, was in Hörgeräte-Anwendungen erwünscht sein kann.

Ein weiterer Vorteil beim erfindungsgemässen Hörgeräte-Verstärker ergibt sich aus der Tatsache, dass mit kleiner werdendem $U_1$ nicht nur der Ruhestrom I verkleinert wird, sondern auch die Rauschspannung, die im Modulator 2 dem Nutzsignal $U_2$ unerwünscht beigemischt wird. Dadurch erhöht sich die Dynamik des Modulators um den gleichen Faktor, wie $U_4$ vom Maximalwert auf seinen Minimalwert (bei kleinerem Pegel von $U_1$) abgesenkt wird.

## Patentansprüche

1. Hörgerät mit einer Verstärkerschaltung mit geschaltetem Verstärker (2), dadurch gekennzeichnet, dass die Verstärkerschaltung derart ausgebildet ist, dass die Pulsamplitude des geschalteten Ausgangssignals des geschalteten Verstärkers (2) in Abhängigkeit der Hüllkurve des zu verstärkenden Tonsignals verändert wird.

2. Hörgerät nach Anspruch 1, dadurch gekennzeichnet, dass dem geschalteten Verstärker (2) ein steuerbarer Verstärker (1) vorgeschaltet ist, der vom zu verstärkenden Tonsignal so gesteuert wird, dass das Produkt der Verstärkungen vom steuerbaren Verstärker (1) und vom geschalteten Verstärker (2) für alle Pegel des zu verstärkenden Tonsignals konstant bleibt.

3. Hörgerät nach Anspruch 2, dadurch gekennzeichnet, dass die Charakteristik der Abhängigkeit der Verstärkung des steuerbaren Verstärkers (1) vom Pegel des Tonsignals das Produkt der Verstärkungen vom steuerbaren Verstärker (1) und vom geschalteten Verstärker (2) nicht konstant bleiben lässt, sondern eine Expansion oder Kompression des Tonsignals bewirkt.

## Revendications

1. Appareil de correction auditive avec un circuit amplificateur avec un amplificateur commuté (2), caractérisé en ce que le circuit amplificateur est conçu de telle manière que l'amplitude de l'impulsion du signal de sortie commuté de l'amplificateur commuté (2) est change en fonction de la courbe enveloppante de l'audio-signal à amplifier.

2. Appareils de correction auditive selon la revendication 1, caractérisé en ce que l'amplificateur commuté (2) est précédé en série d'un amplificateur réglable (1) par l'audio-signal à amplifier d'une manière telle que le produit des amplifications de l'amplificateur réglable (1) et de l'amplificateur commuté (2) reste constant pour tous les niveaux de l'audio-signal à amplifier.

3. Appareils de correction auditive selon la revendication 2, caractérisé en ce que la caractéristique de l'amplification de l'amplificateur réglable (1) en fonction du niveau de l'audio-signal ne laisse pas rester constant le produit des amplifications de l'amplificateur réglable (1) et de l'amplificateur commuté (2), mais provoque une expansion ou compression de l'audio-signal.

## Claims

1. A hearing aid having an amplifier circuit with a switched amplifier (2), characterized in that the circuit of the amplifier is designed in such a manner that the pulse amplitude of the switched output signal of the switched amplifier (2) is adjusted in dependence of the envelope curve of the audio signal to be amplified.

2. The hearing aid of claim 1, characterized in that a controllable amplifier (1) is connected in series ahead of the switched amplifier (2) and is adapted to be controlled by the audio signal to be amplified in such a manner that the product of the amplification of the switched amplifier (2) and the controllable amplifier (1) remains constant for all levels of the audio signal to be amplified.

3. The hearing aid of claim 2, characterized in that the characteristic of the dependency of the amplifications of the controllable amplifier (1) from the level of the audio signal does not let remain constant the product of the amplifications of the controllable amplifier (1) and the switched amplifier (2), but causes an expansion or compression of the audio signal.

Fig1

Fig2

Fig3